# EUROPEAN PATENT APPLICATION

(11) **EP 2 680 277 A1**
(43) Date of publication of application: **01.01.2014**
(21) Application number: 13159735.3
(22) Date of filing: 18.03.2013
(51) Int. Cl.: H01C 1/08, H01C 1/084, H01C 7/00

(54) **Chip resistor**

(30) Priority: 25.06.2012 TW 101212157
(71) Applicant: Ralec Electronic Corporation, 811 Kaohsiung (TW)
(72) Inventor: Chen, Full, 804 Kaohsiung City (TW)
(74) Representative: Zimmermann, Tankred Klaus

(57) **Abstract**

A chip resistor includes a resistor main body (21), an insulating layer (22), a heat dissipating layer (23), and two electrodes (24). The resistor main body (21) is formed with plural longitudinally extending slits (211) arranged and spaced apart from one another. The resistor main body (21) has transversely opposite ends (214) connected electrically and respectively to the electrodes (24). The heat dissipating layer (23) dissipates heat generated by the resistor main body (21) and is formed with a dividing slot(231) extending across one of the slits (211) and dividing the heat dissipating layer (23) into two transversely spaced-apart portions (233, 234). The insulating layer (22) is sandwiched between the resistor main body (21) and the heat dissipating layer (23) and electrically insulates the heat dissipating layer (23) from the resistor main body (21).

## Description

This invention relates to a passive component, more particularly to a chip resistor.

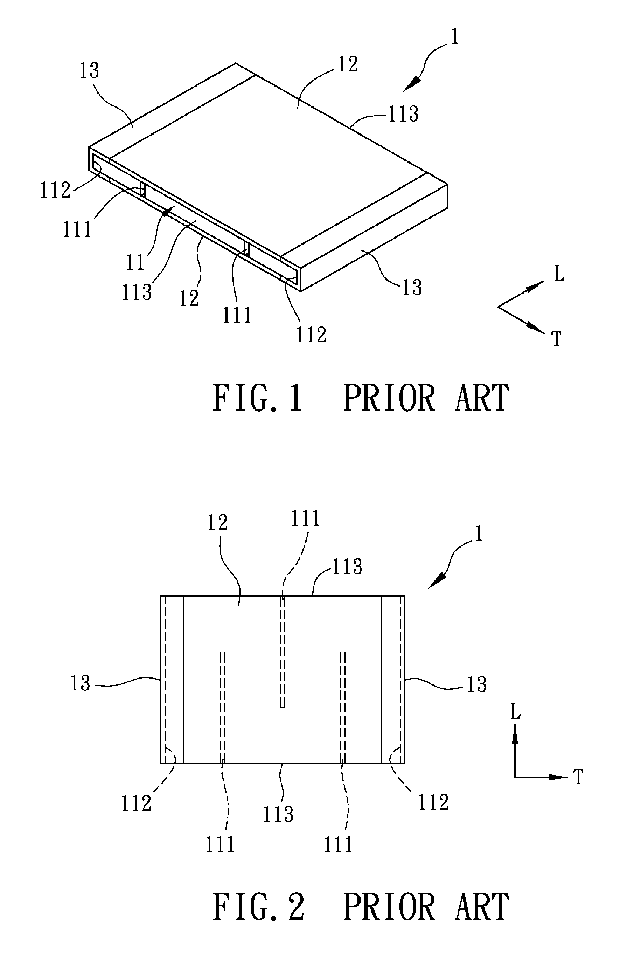

Referring to FIGS. 1 and 2, a conventional chip resistor 1 includes a resistor main body 11, two coating layers 12, and two electrodes 13. The resistor main body 11 is formed with a plurality of slits 111 that extend in a longitudinal direction (L), and has a pair of ends 112 that are opposite to each other in a transverse direction (T) perpendicular to the longitudinal direction (L) and a pair of lateral sides 113 opposite to each other in the longitudinal direction (L). Every adjacent two of the slits 111 extend from and penetrate through the lateral sides 113, respectively. The coating layers 12 are coated on opposite surfaces of the resistor main body 11, respectively. The electrodes 13 are electrically connected to the ends 112 of the resistor main body 11, respectively.

The resistance value of a resistor is directly proportional to a product of an electrical resistivity of material of the resistor and a length of current path, and is inversely proportional to a cross-sectional area of the resistor in thickness. Accordingly, in order to increase the resistance value of the conventional chip resistor 1, the thickness of the resistor main body 11 is decreased and/or a number of the slits 111 is increased for lengthening the length of a current path, resulting in a relatively weak structural strength of the conventional chip resistor 1.

Moreover, since the coating layers 12 cover the opposite surfaces of the resistor main body 11, it is difficult to dissipate heat generated by the resistor main body 11 and temperature of the conventional chip resistor 1 is thus increased dramatically during use. As a consequence, the resistance value and the resistance characteristic of the conventional chip resistor 1 are affected adversely due to the increased temperature. Additionally, the coating layers 12 have to be made of a heat-resistant material and thus manufacturing cost of the conventional chip resistor 1 is increased.

The object of the present invention is to provide a chip resistor having relatively good structural strength and capable of dissipating heat effectively.

According to this invention, a chip resistor comprises a resistor main body, a heat dissipating layer, an insulating layer, and two electrodes. The resistor main body is formed with a plurality of slits that extend in a longitudinal direction and that are arranged and spaced apart from one another in a transverse direction perpendicular to the longitudinal direction. The resistor main body has a pair of ends opposite to each other in the transverse direction. The heat dissipating layer is adapted to dissipate heat generated by the resistor main body and is formed with at least one slot that extends across at least one of the slits and that divides the heat dissipating layer into at least two portions spaced apart from each other in the transverse direction. The insulating layer is sandwiched between the resistor main body and the heat dissipating layer and electrically insulates the heat dissipating layer from the resistor main body. The electrodes are electrically and respectively connected to the ends of the resistor main body.

Other features and advantages of the present invention will become apparent in the following detailed description of the preferred embodiment of the invention, with reference to the accompanying drawings, in which:
FIG. 1 is a perspective view of a conventional chip resistor;
FIG. 2 is a schematic top view of the conventional chip resistor;
FIG. 3 is a perspective view of a preferred embodiment of a chip resistor according to the present invention;
FIG. 4 is a schematic bottom view of the chip resistor including a resistor main body formed with a plurality of slits;
FIG. 5 is a schematic top view of the chip resistor including a heat dissipating layer formed with a dividing slot;
FIG. 6 is a schematic top view of the chip resistor for illustrating a modification of the dividing slot that includes a plurality of segments in a zigzag arrangement;
FIG. 7 is a schematic top view of the chip resistor for illustrating the heat dissipating layer formed with a plurality of the dividing slots;
FIG. 8 is a flow chart of a method of manufacturing the chip resistor of the preferred embodiment;
FIG. 9 is a perspective view of a semi-product that is formed during manufacture of the chip resistor of the preferred embodiment;
FIG. 10 is a perspective view of the semi-product formed with a plurality of resistor sections arranged in an array;
FIG. 11 is a fragmentary enlarged view of FIG. 10;
FIG. 12 is a schematic bottom view of the semi-product, where each of the resistor sections is formed with a plurality of slits to form the resistor main body;
FIG. 13 is a schematic top view of the semi-product, where each of the resistor sections is formed with a dividing slot; and
FIG. 14 is a schematic top view of the semi-product, where two electrodes are formed on opposite ends of each resistor main body.

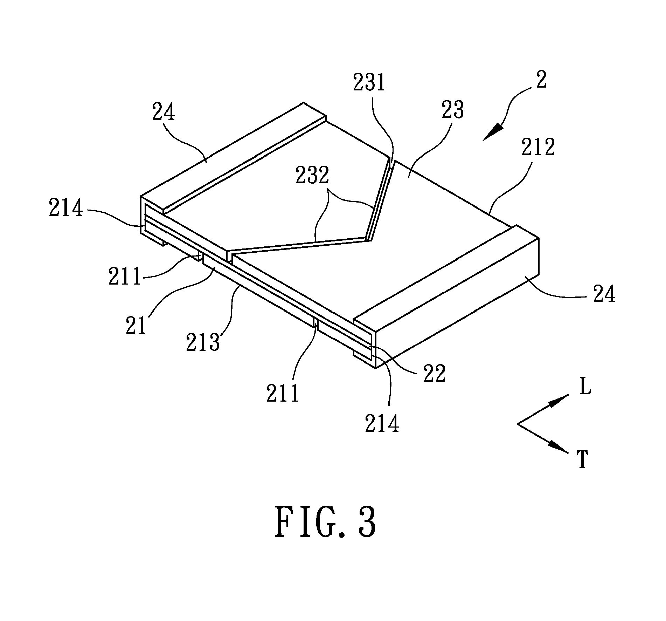

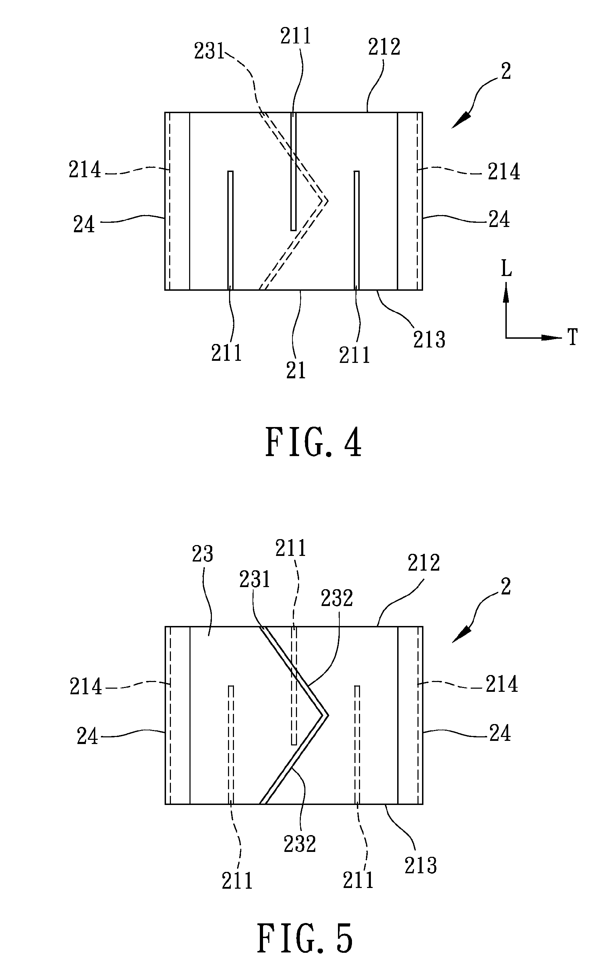

Referring to FIGS. 3 to 5, the preferred embodiment of a chip resistor 2 according to the present invention is shown to include a resistor main body 21, an insulating layer 22, a heat dissipating layer 23, and two electrodes 24.

The resistor main body 21 is formed with a plurality of slits 211 that extend in a longitudinal direction (L) and that are arranged and spaced apart from one another in a transverse direction (T) perpendicular to the longitudinal direction (L). The resistor main body 21 has a pair of ends 214 opposite to each other in the transverse direction (T), and a pair of lateral sides 212, 213 parallelly extending in the transverse direction (T) and opposite to each other in the longitudinal direction (L). Every adjacent two of the slits 211 extend from and penetrate through the lateral sides 212, 213, respectively. By this configuration, current flows through the resistor main body 21 along a serpentine current path (i.e., a zigzag current path), and a desired resistance value of the chip resistor 2 can be achieved. The resistor main body 21 is made of a material selected from the group consisting of copper, aluminum, copper alloy, aluminum alloy, and copper aluminum alloy. Note that, although the resistor main body 21 is formed with three slits 211 in this embodiment, the number of the slits 211 can be varied according to a desired resistance value in other embodiments.

The heat dissipating layer 23 is for dissipating heat generated by the resistor main body 21 during use of the chip resistor 2, and is formed with a dividing slot 231 that extends across one of the slits 211 and that divides the heat dissipating layer 23 into two portions spaced apart from each other in the transverse direction (T). In this embodiment, the dividing slot 231 of the heat dissipating layer 23 has two segments 232 which form an obtuse angle therebetween and each of which extends inclinedly from one of the lateral sides 212, 213 toward the other one of the lateral sides 212, 213. The heat dissipating layer 23 is made of a material selected from the group consisting of copper, aluminum, copper alloy, aluminum alloy, and copper aluminum alloy.

The insulating layer 22 is sandwiched between the resistor main body 21 and the heat dissipating layer 23, and electrically insulates the heat dissipating layer 23 from the resistor main body 21. The insulating layer 22 has relatively high thermal conductivity and is made of a polymer material, such as polypropylene, so as to facilitate conduction of the heat generated by the resistor main body 21 to the heat dissipating layer 23.

The electrodes 24 are electrically and respectively connected to the ends 214 of the resistor main body 21, and are configured to be electrically connected to an electronic device, such as a circuit board (not shown).

In use, current flows from one of the electrodes 24 through the main resistor body 21 via the current path toward the other one of the electrodes 24. The heat generated by the resistor main body 21 can be effectively transmitted through the insulating layer 22 to the heat dissipating layer 22, and then, is dissipated by the heat dissipating layer 23 to the ambient. As a result, the temperature of the chip resistor 2 remains relatively low as compared to the conventional chip resistor 1, and the resistance value and the resistance characteristic of the chip resistor 2 are not affected. Additionally, since the heat dissipation capability of the chip resistor 2 is relatively good, it is not necessary to select a heat-resistant material for manufacturing the chip resistor 2, thereby reducing manufacturing cost.

The resistance value of the chip resistor 2 is determined by the material of the resistor main body 21, a cross-sectional area of the resistor main body 21, and a length of the current path. When the thickness of the resistor main body 21 is reduced and/or the number of slits 211 formed on the resistor main body 21 is increased in order to increase the resistance value of the chip resistor 2, the structural strength of the chip resistor 2 can be ensured by virtue of the heat dissipating layer 23 that is made of metallic material. As a result, the chip resistor 2 of the present invention can be applied to a wider range of resistance values. Since the heat dissipating layer 23 is formed with the dividing slot 231, current will not flow through the heat dissipating layer 23. Further, since the dividing slot 231 extends across one of the slits 211, there is no stress concentration on the resistor main body 21 and the heat dissipating layer 23.

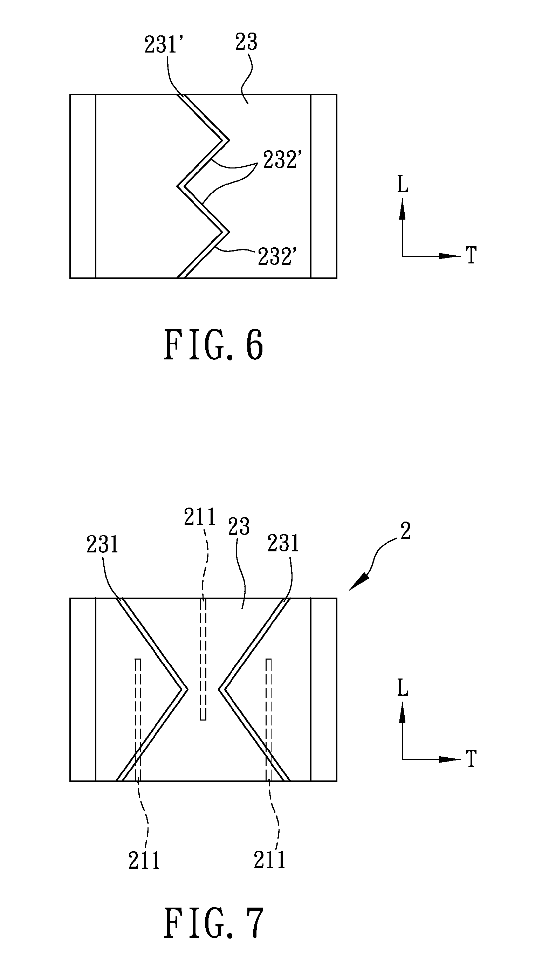

Referring to FIG. 6, a modification of the dividing slot 231' formed on the heat dissipating layer 23 is shown. The dividing slot 231' includes a plurality of segments 232' in a zigzag arrangement, and every adjacent two of the segments 232' form an obtuse angle therebetween.

As shown in FIG. 7, the heat dissipating layer 23 is formed with two dividing slots 231. The dividing slots 231 divide the heat dissipating layer 23 into three spaced-apart portions in the transverse direction (T), and two of them extend across two of the slits 211, respectively.

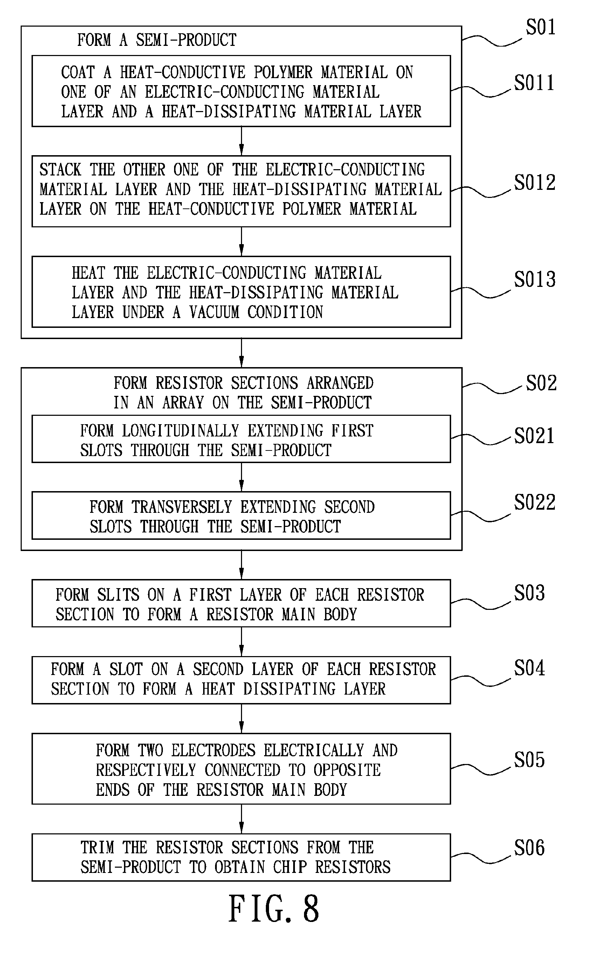

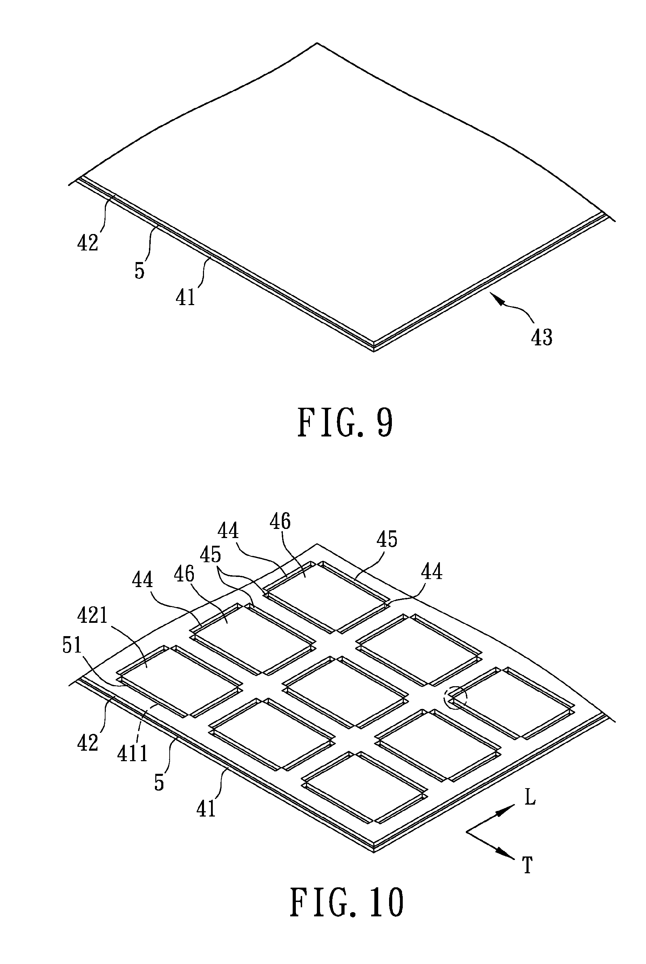

Referring to FIG. 8, a method of manufacturing the chip resistor 2 of the preferred embodiment comprises the following steps. Further referring to FIG. 9, in step S01, an electric-insulating material layer 5 is sandwiched between an electric-conducting material layer 41 and a heat-dissipating material layer 42 to form a semi-product 43 by the following sub-steps. In sub-step S011, heat-conductive polymer material is coated on one of the electric-conducting material layer 41 and the heat-dissipating material layer 42. In sub-step S012, the other one of the electric-conducting material layer 41 and the heat-dissipating material layer 42 is stacked on the heat-conductive polymer material. Insub-step S013, the electric-conducting material layer 41 and the heat-dissipating material layer 42 are heated under a vacuum condition to solidify the heat-conductive polymer material serving as the electric-insulating material layer 5, thereby forming the semi-product 43.

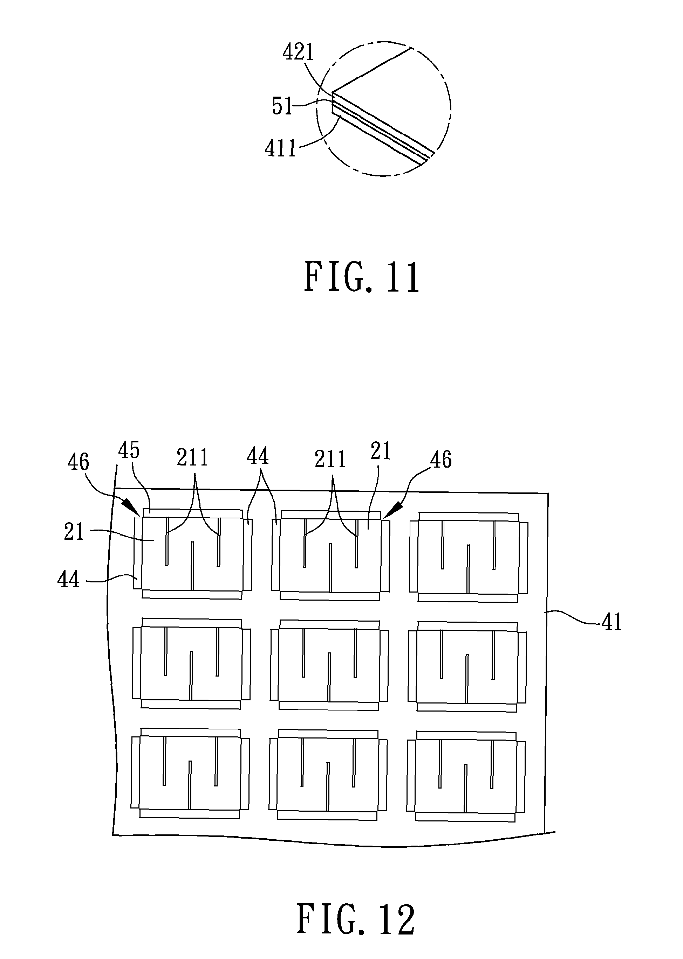

Further referring to FIGS. 10 and 11, in step S02, a plurality of resistor sections 46 arranged in an array are formed on the semi-product 43 by the following steps. In sub-step S021, a plurality of first slots 44 are formed through the semi-product 43. The first slots 44 extend in the longitudinal direction (L) and are arranged in aplurality of rows. Each row of the first slots 44 includes a plurality of adjacent pairs of the first slots 44. In sub-step S022, a plurality of second slots 45 are formed through the semi-product 43. The second slots 45 extend in the transverse direction (T) and are arranged in a plurality of columns. Each adjacent pair of the second slots 45 cooperate with a corresponding adjacent pair of the first slots 44 to surround and define one of the resistor sections 46. Each of the resistor sections 46 has a first layer 411 which is a segment cut from the electric-conducting material layer 41, a second layer 421 which is a segment cut from the heat-dissipating material layer 42, and a sandwiched layer 51 which is a segment cut from the electric-insulating material layer 5.

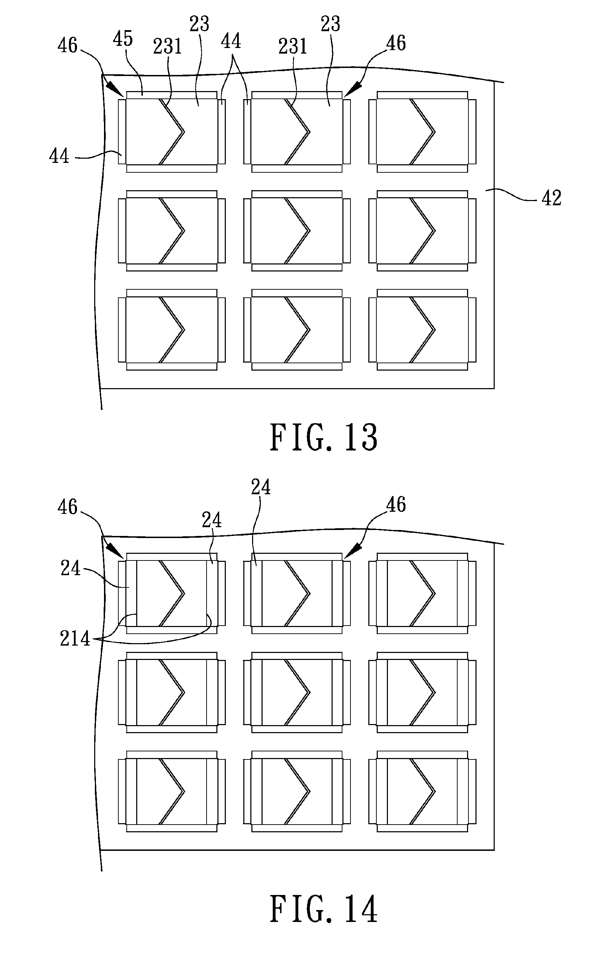

Referring to FIG. 12, in step S03, for each resistor section 46, a plurality of slits 211 are formed on the first layer 411 of the resistor section 46 by masking and etching to form the resistor main body 21. Referring to FIG. 13, in step S04, for each resistor section 46, a dividing slot 231 is formed on the second layer 421 of the resistor section 46 by masking and etching to form the heat dissipating layer 23. The dividing slot 231 extends across one of the slits 211 and divides the second layer 421 of the resistor section 46 into the portions that are spaced apart from each other in the transverse direction (T).

Referring to FIG. 14, in step S05, for each resistor section 46, two electrodes 24 are formed to be electrically and respectively connected to the ends 214 of the resistor main body 21 by masking and electroplating. Finally, in step S06, each of the resistor sections 46 is trimmed from the semi-product 43 to obtain the chip resistor 2 illustrated in FIG. 3.

To sum up, by virtue of the heat dissipating layer 23 that facilitates heat dissipation of the resistor main body 21 during use, the temperature of the chip resistor 2 is relatively low as compared to the conventional chip resistor 1 illustrated in FIGS. 1 and 2. Thus, the resistance value and the resistance characteristic of the chip resistor 2 remain stable, and the material for making the chip resistor 2 may not be a heat-resistant material, thereby reducing manufacturing cost. Additionally, the heat dissipating layer 23 made of metallic material ensures the structural strength of the chip resistor 2 when the thickness of the resistor main body 21 is reduced and/or the number of slits 211 is increased.

## Claims

1. A chip resistor including:
a resistor main body (21) formed with a plurality of slits (211) that extend in a longitudinal direction (L) and that are arranged and spaced apart from one another in a transverse direction (T) perpendicular to the longitudinal direction (L), said resistor main body (21) having a pair of ends (214) opposite to each other in the transverse direction (T);
**characterized by**
a heat dissipating layer (23) adapted to dissipate heat generated by said resistor main body (21) and formed with at least one dividing slot (231) that extends across at least one of said slits (211) and that divides said heat dissipating layer (23) into at least two portions (233, 234) spaced apart from each other in the transverse direction (T);
an insulating layer (22) sandwiched between said resistor main body (21) and said heat dissipating layer (23) and electrically insulating said heat dissipating layer (23) from said resistor main body (21); and
two electrodes (24) electrically and respectively connected to said ends (214) of said resistor main body (21).

2. The chip resistor as claimed in claim 1, **characterized in that** said dividing slot (231) of said heat dissipating layer (23) includes two segments (232) which form an obtuse angle therebetween.

3. The chip resistor as claimed in claim 1, **characterized in that** said dividing slot (231) includes a plurality of segments (232') in a zigzag arrangement, every adj acent two of said segments (232') forming an obtuse angle therebetween.

4. The chip resistor as claimed in claim 1, **characterized in that** said insulating layer (22) is thermal conductive and is made of a polymer material.

5. The chip resistor as claimed in claim 4, further **characterized in that** said insulating layer (22) is made of polypropylene.

6. The chip resistor as claimed in claim 1, **characterized in that** said resistor main body (21) further has a pair of lateral sides (212, 213) parallelly extending in the transverse direction (T) and opposite to each other in the longitudinal direction (L), every adjacent two of said slits (211) extending from and penetrating through said lateral sides (212, 213), respectively.

7. The chip resistor as claimed in claim 1, **characterized in that** said resistor main body (21) is made of a material selected from the group consisting of copper, aluminum, copper alloy, aluminum alloy, and copper aluminum alloy.

8. The chip resistor as claimed in claim 1, **characterized in that** said heat dissipating layer (23) is made of a material selected from the group consisting of copper, aluminum, copper alloy, aluminum alloy, and copper aluminum alloy.
